# EUROPÄISCHE PATENTANMELDUNG

(11) **EP 3 104 278 A1**
(43) Veröffentlichungstag der Anmeldung: **14.12.2016**
(21) Anmeldenummer: 15171801.2
(22) Anmeldetag: 12.06.2015
(51) Int. Cl.: G06F 11/30, G06F 11/34, G06F 17/50

(54) **VERFAHREN ZUR REALISTISCHEN ABSCHÄTZUNG VON FUNKTIONSLAUFZEITEN IN PIL SIMULATION**

(71) Anmelder: dSPACE digital signal processing and control engineering GmbH, 33102 Paderborn (DE)
(72) Erfinder: Lünstroth, Frank, 33129 Delbrück (DE); Hillebrand, Sebastian, 34431 Marsberg (DE); Fischer, Karsten, 33098 Paderborn (DE)

(57) **Zusammenfassung**

Die Erfindung betrifft ein Verfahren und eine Vorrichtung zur Bestimmung einer Laufzeit, welche von einer Funktion eines Steuerungsprogramms für eine Steuergeräteeinheit in einem Echtzeitsystem benötigt wird, ausgeführt auf einem Zielprozessor in einer Processor-in-the-loop (PIL) Simulation, wobei das Verfahren Erstellen oder Laden eines graphischen Entwicklungsmodells der Steuergeräteeinheit in eine Entwicklungsumgebung, wobei das graphische Entwicklungsmodell Funktionalität der Steuergeräteeinheit mittels Funktionsblöcken im graphischen Entwicklungsmodell abbildet; Auswählen mindestens eines Funktionsblocks innerhalb des graphischen Entwicklungsmodells, insbesondere Auswählen eines Funktionsblocks über eine graphische Benutzeroberfläche; und automatisches Generieren des Steuerungsprogramms zur Ausführung auf dem Zielprozessor entsprechend dem graphischen Entwicklungsmodell, wobei das Steuerungsprogramm die Funktion umfasst, welche die Funktionalität des ausgewählten Funktionsblocks abbildet, umfasst. Ferner wird ein erster Laufzeitmesspunkt assoziiert mit dem Anfang und ein zweiter Laufzeitmesspunkt assoziiert mit dem Ende der Funktion im Steuerungsprogramm, in das Steuerungsprogramm und unmittelbar vor dem ersten Laufzeitmesspunkt der für eine Ausführung der Funktion wird der verwendete Cache des Zielprozessors in einen vorbestimmten Zustand versetzt und beim Ausführen des Steuerungsprograms auf dem Zielprozessor an dem ersten und zweiten Laufzeitmesspunkten Laufzeitwerte gemessen werden, aus denen die Laufzeit bestimmt wird.

## Beschreibung

### Gebiet der Erfindung

Die Erfindung betrifft die Messung und Bestimmung von Laufzeiten von Funktionen in einer Processor-in-the-loop (PIL) Simulation.

### Hintergrund

Mit der Zunahme der Benutzung eingebetteter Systeme in zahlreichen Gebieten der Technik zur Ausführung von Überwachungs-, Steuerungs- oder Regelfunktionen und/oder zur Daten- bzw. Signalverarbeitung, ist eine entsprechende Abstimmung zwischen verwendeten Steuerungsprogrammen und der Hardware, insbesondere des verwendeten Prozessors zum festen Bestandteil von Entwicklungsprozessen geworden. Dabei ist ein Testen der Kombination aus Steuerungsprogramm und Hardware in verschiedenen Entwicklungsstadien wünschenswert, um etwaige Probleme bei der Ausführung von Überwachungs-, Steuerungs- oder Regelfunktionen frühzeitig zu erkennen und eine Anpassung entweder der verwendeten Hardware oder eine Anpassung der Funktionen vornehmen zu können.

Zur Entwicklung der Steuerungsprogramme, z. B. Software-Code für Steuergeräte in der Automobilindustrie, werden zunehmend modellbasierte Entwicklungswerkzeuge verwendet. Diese ermöglichen es, die Funktionalität des Steuerungsprogramms zunächst graphisch, in Form von Modellen, in der Regel mit Blockschaltbilder, zu spezifizieren. Die Spezifikation der Funktionalität erfolgt hierbei auf einer höheren Abstraktionsebene als eine Spezifikation auf der Ebene von textuellem Software-Code wie etwa C-Code. Dies ermöglicht einerseits eine bessere Übersichtlichkeit über die Funktionalität des Steuerungsprogramms, andererseits lassen sich solche Modelle besser wiederverwerten, da sie aufgrund des höheren Abstraktionsniveaus allgemeineren Charakter haben und noch nicht auf eine konkrete Weise der Implementierung und/oder der Programmierung festgelegt sind. Weitere Vorteile bei der Verwendung modellbasierter Entwicklungswerkzeuge ergeben sich zum einen dadurch, dass die Funktionalität der Modelle schon auf einer hohen Abstraktionsebene getestet werden kann, d.h. das Modell kann in sogenannten "Model-in-the-loop" (MIL)-Tests ausgeführt und auf Fehler seiner Funktionalität überprüft werden. Zum anderen kann auf Basis eines Modells von einem Codegenerator automatisch Code für ein Steuerungsprogramm erzeugt werden. Dies ist beispielsweise C-Code, der auf einem Steuergeräte-Prozessor ablaufen kann oder etwa VHDL-Code für einen FPGA oder ASIC.

Der erzeugte Code kann dann in einer nächsten Teststufe getestet werden. Das Testen des Software-Codes wird auch als "software-in-the-loop" (SIL) bezeichnet. Der Code wird dabei auf Fehler bezüglich seiner Funktionalität geprüft, indem nun auch Codierungs-spezifische Eigenschaften und/oder Limitierungen Berücksichtigung finden, so zum Beispiel Verwendung von Festkomma statt Gleitkommazahlen. In einem weiteren Schritt kann der Code auch auf einem externen Zielprozessor ausgeführt werden. In diesem Fall spricht man von einer "Processor-in-the-Loop"-Simulation, bei der nun auch Prozessor-spezifische Eigenschaften und/oder Limitierungen Berücksichtigung finden, so zum Beispiel Ziel-Compiler und Prozessor-Taktrate.

Zum Überprüfen der Funktionalität des Software-Codes ausgeführt auf dem Zielprozessor wird oft in einem ersten Schritt sogenannter "instrumentierter Programmcode" als Steuerungsprogramm mittels des Codegenerators erzeugt und ausgeführt. Der instrumentierte Code ist nicht vollständig optimiert, sondern enthält z. B. zusätzliche Logging-Makros mittels derer während der Testphase nachgehalten wird, welche Programmteile oder Funktionen wie häufig durchlaufen oder aufgerufen werden und welche Werte für z.B. Ausgangsvariablen berechnet wurden. Solche Informationen, die der Software-Entwickler durch das Aufzeichnen von Daten bei Testdurchläufen erhält, werden als "Profiling- oder Tracing-Informationen" bezeichnet. Diese Profiling-Informationen können auf einen angeschlossenen PC übertragen werden, wo sie für Analyse- und Auswertungszwecke bereitstehen.

Von besonderem Interesse ist die Abschätzung von Laufzeitinformationen, d.h. der vom Prozessor benötigten Zeit ein Steuerungsprogramm auszuführen. Speziell eine Abschätzung für das 'worst case' Szenario, also die längste Laufzeit kann insbesondere für Steuergeräte, welche sicherheitsrelevanten Routinen in Echtzeit steuern, wie z.B. Antiblockiersystem oder Airbag in einem Auto, essentiell sein, um eine garantierte Antwort- bzw. Reaktionszeit zu erhalten.

Die Ausführungszeiten von Steuerungsprogrammen hängen dabei maßgeblich von Speicherzugriffszeiten ab. Moderne Prozessoren, die eine schnelle Datenverarbeitung benötigen, sind daher mit sogenannten Caches ausgestattet. Caches sind Zwischenspeicher im oder nahe dem Prozessor-Kern, die die zuletzt verarbeiteten Daten und Befehle aus dem Hauptspeicher (RAM/Flash/ROM) zwischenspeichern und so die rasche Wiederverwendung ermöglichen, z.B. bei wiederholter Ausführung von identischen Codeteilen in einer Schleife.

Da aufgrund von Chip-Herstellungskosten die Größe des Cache begrenzt ist, ist es die Regel, dass der Speicherplatz nicht ausreicht die Instruktionen aller Tasks, Funktionen und/oder alle Daten 'nebeneinander' und somit permanent in den Cache zu laden. Um eine garantierte oder zumindest optimierte Antwortzeit der (zeit)kritischen Funktionen zu ermöglichen, werden Funktionen in Echtzeitsystemen weiterhin oftmals priorisiert und Funktionen mit niedriger Priorität können unterbrochen werden, wenn eine Funktion mit höherer Priorität vorranging berechnet werden soll. Dies wird auch als Taskwechsel bezeichnet.

In der DE 10034459 A1 wird ein Verfahren zur Laufzeitmessung einer Task unter Berücksichtigung auftretender Taskwechsel beschrieben. Dabei wird ein Zeitmesser für jede Task gestartet und dieser bei jedem Wechsel der Prioritätsebene angehalten und erst bei Wiederaufnahme der Task in der ursprünglichen Prioritätsebene weiterlaufen gelassen.

Bei Taskwechseln und auch bei Funktionen/Daten oberhalb der Cache-Größe kann es nun sein, dass ggf. früher mal bereits in den Cache geladene Instruktionen und/oder Daten, welche zur Ausführung einer Funktion benötigt werden, nun nicht mehr verfügbar sind und erneut aus dem Speicher in den Cache geladen werden müssen. Ein erneutes Laden der benötigten Instruktionen und/oder Daten geht somit z.B. zu Lasten der Laufzeit einer unterbrochenen Task. Ein erneutes Laden kann ferner nötig werden, wenn das Speicherabbild im Cache nicht mehr aktuell ist, d.h. Inkonsistenzen mit dem Hauptspeicher aufweist. In solchen Fällen bezeichnet man den Cache als invalide.

Simulationen, wie sie Gegenstand der vorliegenden Anmeldung sind, laufen nicht in Echtzeit. Sowohl in SIL als auch in PIL Simulationen gibt es gewöhnlich keine mehreren Tasks, so dass Taskwechsel nicht auftreten. Ferner ist die simulierte Funktionalität eines Modells oftmals viel kleiner als die Applikation auf einem später eingesetzten Steuergerät (da es sich hier i.d.R. um Komponenten/Unit-Tests handelt) und der gesamte Programmcode somit u.U. in den Cache passt.

Um eine realistische Abschätzung der späteren Laufzeit im Echtzeitsystem zu erhalten, ist es daher wünschenswert zum einen den "best case" ermitteln, also die Zeit die der Prozessor benötigt eine einzelne Funktionalität exklusiv auszuführen, die den Cache komplett für sich nutzen kann. Zum anderen möchte man die Ausführungszeit im "worst case" messen, die für die Ausführung einer Funktion benötigt, wenn der Cache belastet oder invalide ist und die die Funktionalität abbildenden Instruktionen und Daten zunächst in den Cache geladen und anschließend ausgeführt werden muss.

Ein Einfügen von Mess-Code innerhalb der Funktion würde den Cache der CPU verändern und so die Messung verfälschen. Zum genauen Messen von Funktionen wird deshalb bisher z.B. externe Trace/Debug-Hardware an ein PIL-Evaluationsboard angeschlossen, welche Messungen per Hardware-Schnittstelle während der PIL-Simulation durchführt.

Alternativ werden "worst case" Laufzeiten durch statische Analyse (ohne Simulation) ermittelt. Diese liefern aber meist zu hohe Laufzeiten, weil sie Abhängigkeiten zwischen verschiedenen (externen) Eingangsgrößen nicht erkennen können.

### Die Erfindung im Überblick

Aufgabe der vorliegenden Erfindung ist ein verbessertes Verfahren zur Abschätzung von Laufzeiten einzelner Funktionen eines Steuerungsprogramms ausgeführt auf einem Zielprozessor bereitzustellen.

Die Aufgabe wird gelöst durch ein Verfahren zur Bestimmung einer Laufzeit, welche von einer Funktion eines Steuerungsprogramms für eine Steuergeräteeinheit in einem Echtzeitsystem benötigt wird, ausgeführt auf einem Zielprozessor in einer Processor-in-the-loop (PIL) Simulation, wobei das Verfahren umfasst:
- Erstellen oder Laden eines graphischen Entwicklungsmodells der Steuergeräteeinheit in eine Entwicklungsumgebung, wobei das graphische Entwicklungsmodell Funktionalität der Steuergeräteeinheit mittels Funktionsblöcken im graphischen Entwicklungsmodell abbildet;
- Auswählen mindestens eines Funktionsblocks innerhalb des graphischen Entwicklungsmodells, insbesondere Auswählen eines Funktionsblocks über eine graphische Benutzeroberfläche;
- automatisches Generieren des Steuerungsprogramms zur Ausführung auf dem Zielprozessor entsprechend dem graphischen Entwicklungsmodell, wobei das Steuerungsprogramm die Funktion umfasst, welche die Funktionalität des ausgewählten Funktionsblocks abbildet.

Das Verfahren ist dadurch gekennzeichnet, dass ein erster Laufzeitmesspunkt assoziiert mit dem Anfang und ein zweiter Laufzeitmesspunkt assoziiert mit dem Ende der Funktion im Steuerungsprogramm, in das Steuerungsprogramm eingefügt wird und wobei unmittelbar vor dem ersten Laufzeitmesspunkt der für eine Ausführung der Funktion verwendete Cache des Zielprozessors in einen vorbestimmten Zustand versetzt wird. Ferner umfasst es die Schritte:
- Ausführen des Steuerungsprograms auf dem Zielprozessor; wobei an dem ersten und zweiten Laufzeitmesspunkten Laufzeitwerte gemessen werden, aus denen die Laufzeit bestimmt wird.

Im Rahmen der vorliegenden Erfindung wird mit Steuergeräteeinheit eine funktionale Einheit eines Steuergeräts bezeichnet, so dass sowohl ein gesamtes Steuergerät einfacher Struktur oder auch eine einzelne Komponente eines komplexen Steuergeräts umfasst sind. Funktionalitäten der Steuergeräteeinheit werden im graphischen Entwicklungsmodell mittels Funktionsblöcke dargestellt. Dabei können diese Funktionsblöcke komplexe Funktionalität einer abgebildeten Steuerungsroutine darstellen, im Allgemeinen ein Subsystem der abgebildeten Steuergeräteeinheit. Diese werden als übergeordnete Funktionen im ausführbaren Programmcode des Steuerungsprogramms realisiert. Die Funktionsblöcke können auch untergeordnete Funktionen darstellen, welche innerhalb einer Funktionalität der Steuergeräteeinheit, als Unterfunktionen im ausführbaren Steuerungsprogram realisiert wird. Das automatisch generierte Steuerungsprogramm wird unter Berücksichtigung der Eigenschaften des jeweiligen Zielprozessors erstellt.

Der Erfindung liegt die Erkenntnis zugrunde, dass bei der Laufzeitbestimmung einer Funktion im Rahmen von PIL-Simulationen in der modellbasierten Entwicklung Cache-Effekte, wie sie in Echtzeitsystemen, also auch in der späteren Steuergeräte-Applikation, auftreten, Berücksichtigung finden müssen, um eine realistische Abschätzung der benötigten Laufzeiten zu erhalten und gegebenenfalls den Prozessor für das Echtzeit-Steuerungssystem entsprechend dimensionieren zu können oder frühzeitig Anpassung an den Regelungsroutinen vornehmen zu können.

Ein Vorteil der vorliegenden Erfindung besteht darin, dass die Laufzeit einer beliebigen Funktion innerhalb eines Steuergeräteprogramms für verschiedene, beliebige Cache-Zustände in der PIL Simulation ermittelt werden kann und damit bereits in einem frühen Stadium der Entwicklung Effekte, welche im späteren Echtzeitsystem zu erwarten sind, berücksichtigt werden können. Damit kann die Nachbildung von Cache-Effekten bereits in das Entwicklungsstadium der Modellierung integriert werden, um deren Auswirkungen auf die Ausführungszeit auf beliebige Funktionen innerhalb eines Steuergeräteprogrammcodes im Rahmen einer PIL-Simulation simulieren und messen zu können. Der Anwender der vorliegenden Erfindung muss damit nicht eigenhändig lauffähigen Programmcode manipulieren, sondern kann die Laufzeitmessung bereits auf Modellebene anlegen. Es muss ferner weder zusätzliche Trace/Debug-Hardware gekauft und angebunden werden, noch wird der Prozessor-Cache durch den notwendigen Mess-Programmcode belastet, was sonst zur Verfälschung der Messungen bzw. der Laufzeiten des zu vermessenden Steuergeräteprogrammcodes führen würde, im Vergleich zum Lauf ohne Mess-Programmcode.

In einer bevorzugten Ausführungsform der vorliegenden Erfindung ist die Funktion eine Unterfunktion, welche innerhalb einer Hauptfunktion ausgeführt wird. Während bekannte Systeme lediglich die gesamte Laufzeit eines kompletten Programmdurchlaufes messen können, ist es mit der vorliegenden Erfindung möglich, auch für einzelne Unterfunktionen eine realistische Laufzeit zu ermitteln. Speziell für Unterfunktionen niedriger Priorität kann in späteren Echtzeitsystemen ein erneutes Laden in den Cache nach Unterbrechung signifikante Laufzeitveränderungen hervorrufen. Eine spezifische Analyse bis hinunter auf Unterfunktionsebenen ist damit wünschenswert, um eine detaillierte Darstellung der Laufzeitabläufe und eventueller Laufzeitengpässe zu erhalten.

Ein weiterer Vorteil ergibt sich daraus, dass die Messwerte immer zu Beginn und Ende eines Funktions- bzw. Unterfunktionsaufrufes aufgezeichnet werden. So lässt sich neben den Ausführungszeiten als solche auch der jeweilige Zeitpunkt veranschaulichen, zu welchem eine Unterfunktion innerhalb der Hauptfunktion gerechnet wurde und auch welche Unterfunktionen in einer Unterfunktion aufgerufen wurden. Da es ferner zu jedem Rechenschritt eine Ausführungszeit gibt, können daraus sowohl eine mittlere Ausführungszeit, als auch die minimale und maximale Laufzeit berechnet werden.

In einer ersten Fortbildung einer der vorangegangenen Ausführungsformen der vorliegenden Erfindung bildet der vorbestimmte Zustand einen teilweise belasteten Cache ab. Von einem teilweise belasteten Cache spricht man, wenn eine Funktion, d.h. sämtliche zum Ausführen der Funktion relevanten Instruktionen/Daten, teilweise erneut in den Cache geladen werden müssen, was zu einer Verzögerung der Laufzeit führt.

In einer alternativen, zweiten Fortbildung einer der vorangegangenen Ausführungsformen der vorliegenden Erfindung bildet der vorbestimmte Zustand einen leeren Cache ab. Diese Situation entspricht dem 'worst case'- Szenario, welches dann auftritt, wenn eine Funktion komplett in den verwendeten Cache geladen werden muss.

In einer weiteren Fortbildung einer der vorangegangenen Ausführungsformen der vorliegenden Erfindung wird an den Laufzeitmesspunkten zu messenden Werten Speicherplatz außerhalb des Caches zugeordnet. Damit wird sichergestellt, dass die Laufzeitmessung durch das Abspeichern der Werte nicht verfälscht wird.

In einer weiteren Fortbildung der bevorzugten Ausführungsform der vorliegenden Erfindung, wird der teilweise belastete Cache durch eine statistische Mittelung über mehrere Simulationsläufe abgebildet, wobei der Cache nur in einer Teilmenge der Simulationsläufe vor Aufruf der Funktion vollständig geleert wird.

In einer alternativen Fortbildung der bevorzugten Ausführungsform der vorliegenden Erfindung wird der teilweise belastete Cache durch Einfügen zusätzlichen Messcodes innerhalb der zu messenden Funktion abgebildet. Je nach Umfang des verwendeten Messcodes in Bezug auf Cache Zugriffe wird damit eine zusätzliche Cachebelastung erwirkt, die abhängig von der Kapazität des verwendeten Caches zu Laufzeitverzögerungen führen kann.

Einen weiteren Aspekt der vorliegenden Erfindung bildet eine Vorrichtung zum Erstellen und Ausführen einer Processor-in-the-loop (PIL) Simulation zur Bestimmung einer Laufzeit, welche von einer Funktion eines Steuerungsprogramms für eine Steuergeräteeinheit in einem Echtzeitsystem benötigt wird, während der Ausführung auf einem Zielprozessor in der PIL Simulation, wobei die Vorrichtung Mittel zum Erstellen oder Laden eines graphischen Entwicklungsmodells der Steuergeräteeinheit in eine Entwicklungsumgebung, wobei das graphische Entwicklungsmodell Funktionalität der Steuergeräteeinheit mittels Funktionsblöcken abbildet, umfasst. Ferner weist die Vorrichtung Mittel zum Auswählen mindestens eines Funktionsblocks innerhalb des graphischen Entwicklungsmodells, insbesondere Mittel zum Auswählen über eine graphische Benutzeroberfläche, einen Codegenerator zur automatischen Generierung des Steuerungsprogramms zur Ausführung auf dem Zielprozessor entsprechend dem graphischen Entwicklungsmodell, wobei das Steuerungsprogramm die Funktion umfasst, welche die Funktionalität des ausgewählten Funktionsblocks abbildet. Darüber hinaus umfasst die Vorrichtung Übertragungsmittel zum Übertragen des generierten Steuerungsprograms auf den Zielprozessor, Mittel zum Ausführen des Steuerungsprogramms auf dem Zielprozessor, und ist dadurch gekennzeichnet, dass der Codegenerator ausgebildet ist, einen erster Laufzeitmesspunkt assoziiert mit dem Anfang und einen zweiten Laufzeitmesspunkt assoziiert mit dem Ende der Funktion in das Steuerungsprogramm einzufügen und den für eine Ausführung der Funktion verwendeten Cache des Zielprozessors unmittelbar vor dem ersten Laufzeitmesspunkt in einen vorbestimmten Zustand zu versetzten, wobei die Vorrichtung ferner Mittel zum Empfangen und Auswerten der an den Laufzeitmesspunkten bei der Ausführung des Steuerungsprogramms gemessenen Werte aufweist.

Der Benutzer der Vorrichtung kann somit bereits auf Modellebene Analysen bezüglich realistischer Laufzeiten durchführen ohne dabei generierten Steuerprogrammcode händisch manipulieren zu müssen, was nicht nur ausreichende Programmierkenntnisse erfordert, sondern auch das Risiko von fehlerhaften Eingriffen, sowie einer mangelnden Reproduzierbarkeit birgt.

In einer bevorzugten Ausführungsform weist die Vorrichtung Mittel zur Auswertung der Laufzeitmessungen auf, insbesondere zur graphischen Auswertung, wobei die Mittel zur Auswertung der Laufzeitmesspunkte ausgebildet sind, die Funktionsblöcke im ursprünglichen graphischen Entwicklungsmodell mit den ausgewerteten Laufzeitwerten der entsprechenden Funktionen zu annotieren. Hierzu wird während der PIL Simulation eine Datei erzeugt, welche die Laufzeitwerte der entsprechenden Funktion im ausgeführten Programmcode zuordnet. Über ein weiteres Mapping zwischen Funktion im Steuerungsprogramm-Code und dem Funktionsblock im graphischen Modell, kann die graphische Benutzeroberfläche ausgebildet werden, die Darstellung der Funktionsblöcke mit den Laufzeiten zu annotieren.

### Beschreibung der Figuren

Bevorzugte Ausführungsformen der vorliegenden Erfindung werden beispielhaft anhand der beiliegenden Figuren beschrieben.
Figur 1 zeigt eine Modellkomponente einer Steuergeräteeinheit in einer graphischen Modellumgebung mit verschiedenen Funktionsblöcken
Figur 2 zeigt Pseudocode wie er vom Codegenerator auf Basis des graphischen Modells generiert werden könnte, inklusive eingefügter Laufzeitmessfunktions-Aufrufe.

### Detaillierte Beschreibung

Die folgende Beschreibung dient der Veranschaulichung einer beispielhaften Ausgestaltung der vorliegenden Erfindung, hat darüber hinaus jedoch keinen einschränkenden Charakter.

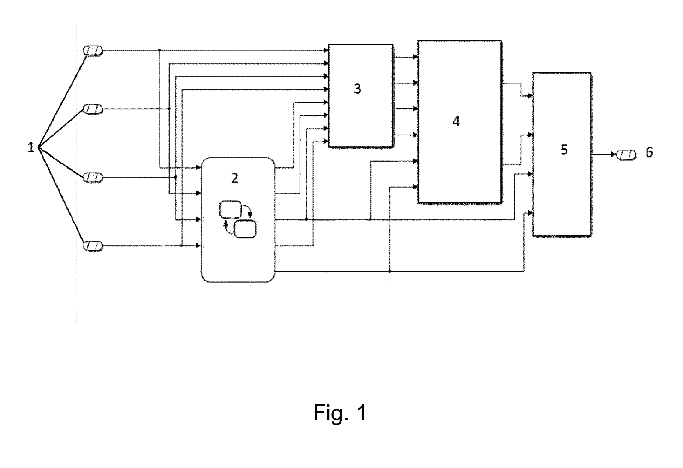

Figur 1 zeigt beispielhaft ein graphisches Modell eines Steuergeräte-Subsystems, welche eine bestimmte Funktionalität eines Steuergeräts steuert, in einer graphischen Modellumgebung. Die Eingangssignale 1, welche von verschiedenen Sensoren stammen können, werden in den Funktionsblock 2, eine Steuerungslogik und den Funktionsblock 3, eine Signalkorrektureinheit, eingespeist. Die Steuerungslogik 2 verarbeitet die Eingangssignale 1 und gibt die verarbeiteten Signale als Eingangssignale an den Funktionsblock 3, eine Signalkorrektureinheit, weiter. Diese verarbeitet alle Eingangssignale und gibt diese an den Funktionsblock 4, eine Berechnungseinheit, weiter. Die Berechnungseinheit 4 erhält ebenfalls noch Eingangssignale von der Steuerungslogik 2. Als letzte Einheit in dem dargestellten Subsystem des Steuergerätemodells, erhält der Funktionsblock 5, eine Berechnungseinheit, die Ausgangssignale der Berechnungseinheit 4 sowie zwei Ausgangssignale der Steuerungslogik 2 und berechnet darauf den Ausgabewert des Subsystems 6.

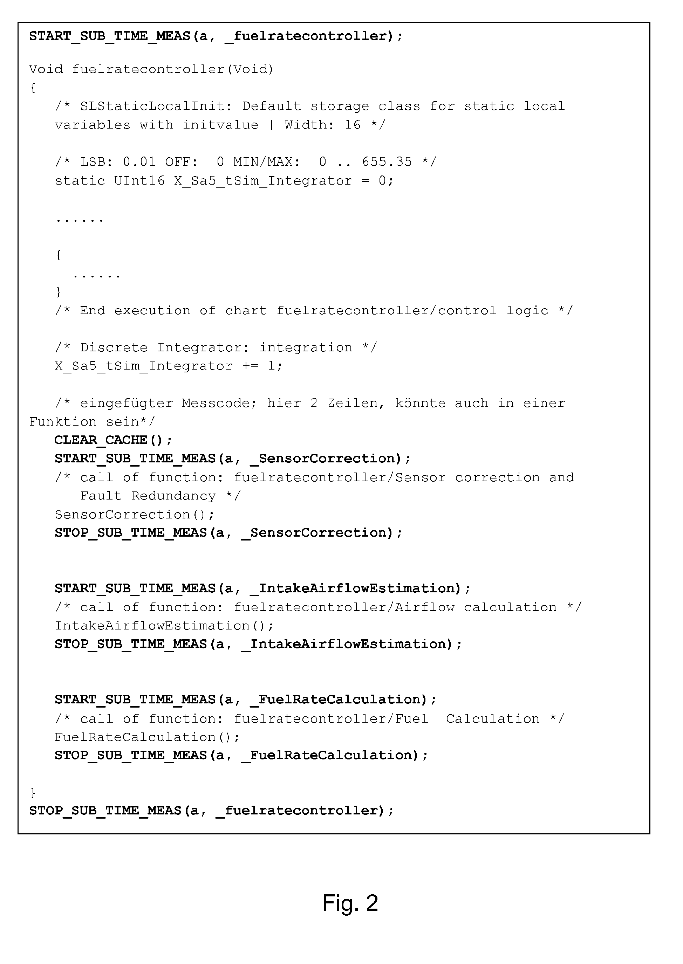

Zur Generierung eines solchen Modells können die einzelnen Einheiten über eine graphische Benutzeroberfläche ausgewählt und mit Hilfe von Eingabemitteln wie einer Mouse/Touchpad oder einem Keyboard miteinander verbunden werden. Der Modellentwickler kann sich dabei einer Vielzahl vordefinierter Funktionsblöcke bedienen oder eigene Funktionsblöcke definieren, indem er Eingangs- und Ausgangsdaten, sowie die Funktionalität eines Funktionsblockes oder eines ganzen Subsystems definiert. In modernen Modellentwicklungsumgebungen kann dann aus den definierten graphischen Modellen automatisch lauffähiger Programmcode, welcher für die bei der späteren Anwendung verwendeten Prozessoren optimiert ist, generiert werden. Generierter Programmcode gemäß dem oben beschriebenen beispielhaften Modell würde aus einer Hauptfunktion für die Steuerungslogik bestehen, in der die Unterfunktionen für die Signalkorrektureinheit 3 sowie die Berechnungseinheiten 4 und 5 aufgerufen würden. Wünscht der Modellentwickler eine Analyse der Laufzeiten einzelner Modelleinheiten, kann er diese zum Beispiel über eine graphische Benutzeroberfläche oder eine Kommandozeilen-API auswählen. Bei einer anschließenden Codegenerierung für das entsprechende Modell und die Übertragung des generierten und kompilierten Programmcodes auf einen für die spätere Anwendung vorgesehenen spezifischen Prozessor vorgegebener Kapazität wird der Programmcode mit Laufzeitmesspunkten, welche mit dem Anfang und Ende des entsprechenden Funktionsaufrufes assoziiert sind, die dem ausgewählten Funktionsblock entspricht, instrumentalisiert. Figur 2 zeigt beispielhaften Programmcode, welcher die Struktur des Beispielmodells mit Laufzeitmesspunkten unmittelbar vor und nach den Funktionsaufrufen abbildet.

Um die Messung der Laufzeit nicht zu verfälschen, werden die Messergebnisse nicht im für die Ausführung des Programmcodes verwendeten Cache gespeichert. Dies kann entweder durch das Einfrieren und Auftauen des Cache per spezieller Prozessor-Instruktion erfolgen, oder die Messzeitaufrufe werden als Funktion in einen nicht im Cache liegenden Speicher gelinkt, wenn der Prozessor die Einfrier-/Auftauen Funktionalität nicht bietet

Somit lässt sich eine Cache-neutrale Laufzeit einer beliebigen Modelleinheit ermitteln. Diese "nackte" Laufzeit bildet somit ein 'best case' Szenario ab, in welchem die Funktion bereits vollständig in den Cache geladen wurde und die Laufzeit lediglich die Rechenzeit abbildet. Eine mögliche Implementierung könnte über logging-Makros erfolgen, die vorteilhafterweise über Präprozessor-Ersetzungen (preprocessor-defines) implementiert werden, welche beim Export des finalen Programmcodes auf das Steuergerät automatisch gelöscht werden, insbesondere durch ein Umdefinieren als leere Anweisung oder durch textuelles Entfernen aus dem Quellcode.

Für die Messung der Laufzeit unter Cache-Belastung kann der Nutzer an dem Funktionsblock im Modell einstellen, dass vor dem Aufruf des entsprechenden Unterprograms der Cache geleert werden soll. Dies kann z.B. durch Generierung eines weiteren Makros in den Code unmittelbar vor dem Funktionsaufruf erfolgen, welches den Cache leert bzw. invalidiert.

Die so ermittelte Laufzeit spiegelt das 'worst case'-Szenario wieder, in welchem die zu einer Funktion gehörenden Instruktionen und Daten jeweils pro (Simulations-) Schritt komplett neu geladen werden muss.

Um eine graduelle Cache-Belastung von z.B. anderen höher-priorisierten Tasks mit zu simulieren, kann der Nutzer auch eine prozentuale Cache-Belastung an dem Funktionsblock im Modell vorgeben. Diese kann ferner randomisiert während der Simulation angewendet werden und den Cache somit vor einigen (Unter-)Funktionsaufrufen löschen/invalidieren (z.B. Cache wird nur bei jedem zweiten Durchlauf invalidiert). Durch Mittelung über mehrere PIL Simulationsdurchläufe erhält der Anwender so eine durchschnittliche Laufzeit für die Ausführung eines bestimmten Funktionsblocks.

Eine solche graduelle Cache-Belastung könnte auch durch zusätzlichen Mess-Code innerhalb einer (Unter-)Funktion simuliert werden, z.B. eingefügt am Anfang einer langen Schleife. Ferner ist es möglich bei den voranstehenden Anwendungen zwischen Instruktions- und Datencache zu unterscheiden, d.h. beide zu invalidieren/belasten oder je nur einen oder keinen, um eine möglichst realistische Abschätzung für die spätere Laufzeitperformance zu erhalten.

So lässt sich neben den Ausführungszeiten als solche auch der jeweilige Zeitpunkt veranschaulichen, zu welchem eine Unterfunktion innerhalb der Hauptfunktion gerechnet wurde und auch welche weiteren Unterfunktionen in einer Unterfunktion aufgerufen wurden. Da es ferner zu jedem Rechenschritt eine Ausführungszeit gibt, können daraus sowohl eine mittlere Ausführungszeit, als auch die minimale und maximale Laufzeit berechnet werden.

## Patentansprüche

1. Verfahren zur Bestimmung einer Laufzeit, welche von einer Funktion eines Steuerungsprogramms für eine Steuergeräteeinheit in einem Echtzeitsystem benötigt wird, ausgeführt auf einem Zielprozessor in einer Processor-in-the-loop (PIL) Simulation, wobei das Verfahren umfasst:
Erstellen oder Laden eines graphischen Entwicklungsmodells der Steuergeräteeinheit in eine Entwicklungsumgebung, wobei das graphische Entwicklungsmodell Funktionalität der Steuergeräteeinheit mittels Funktionsblöcken im graphischen Entwicklungsmodell abbildet;
Auswählen mindestens eines Funktionsblocks innerhalb des graphischen Entwicklungsmodells, insbesondere Auswählen eines Funktionsblocks über eine graphische Benutzeroberfläche;
automatisches Generieren des Steuerungsprogramms zur Ausführung auf dem Zielprozessor entsprechend dem graphischen Entwicklungsmodell, wobei das Steuerungsprogramm die Funktion umfasst, welche die Funktionalität des ausgewählten Funktionsblocks abbildet,
**dadurch gekennzeichnet, dass** ein erster Laufzeitmesspunkt assoziiert mit dem Anfang und ein zweiter Laufzeitmesspunkt assoziiert mit dem Ende der Funktion im Steuerungsprogramm, in das Steuerungsprogramm eingefügt wird und wobei unmittelbar vor dem ersten Laufzeitmesspunkt der für eine Ausführung der Funktion verwendete Cache des Zielprozessors in einen vorbestimmten Zustand versetzt wird;
Ausführen des Steuerungsprograms auf dem Zielprozessor; wobei an dem ersten und zweiten Laufzeitmesspunkten Laufzeitwerte gemessen werden, aus denen die Laufzeit bestimmt wird.

2. Verfahren nach Anspruch 1, wobei die Funktion eine Unterfunktion ist, welche innerhalb einer übergeordneten Funktion ausgeführt wird.

3. Verfahren nach Anspruch 1 oder 2, wobei der vorbestimmte Zustand einen teilweise belasteten Cache abbildet.

4. Verfahren nach Anspruch 3, wobei der teilweise belastete Cache durch eine statistische Mittelung über mehrere Läufe abgebildet wird, und der Cache nur in einer Teilmenge der Läufe vor Aufruf der Funktion geleert wird.

5. Verfahren nach Anspruch 3, wobei der teilweise belastete Cache durch Einfügen zusätzlichen Messcodes innerhalb der zu messenden Funktion abgebildet wird.

6. Verfahren nach Anspruch 1 oder 2, wobei der vorbestimmte Zustand einen leeren Cache abbildet.

7. Verfahren nach einem der vorangegangenen Ansprüche, wobei an den Laufzeitmesspunkten zu messenden Werten Speicherplatz außerhalb des Caches zugewiesen ist.

8. Vorrichtung zum Erstellen und Ausführen einer Processor-in-the-loop (PIL) Simulation zur Bestimmung einer Laufzeit, welche von einer Funktion eines Steuerungsprogramms für eine Steuergeräteeinheit in einem Echtzeitsystem benötigt wird, während der Ausführung auf einem Zielprozessor in der PIL Simulation, wobei die Vorrichtung umfasst:
Mittel zum Erstellen oder Laden eines graphischen Entwicklungsmodells der Steuergeräteeinheit in eine Entwicklungsumgebung, wobei das graphische Entwicklungsmodell Funktionalität der Steuergeräteeinheit mittels Funktionsblöcken abbildet;
Mittel zum Auswählen mindestens eines Funktionsblocks innerhalb des graphischen Entwicklungsmodells, insbesondere Mittel zum Auswählen über eine graphische Benutzeroberfläche;
Codegenerator zur automatischen Generierung des Steuerungsprogramms zur Ausführung auf dem Zielprozessor entsprechend dem graphischen Entwicklungsmodell, wobei das Steuerungsprogramm die Funktion umfasst, welche die Funktionalität des ausgewählten Funktionsblocks abbildet,
Übertragungsmittel zum Übertragen des generierten Steuerungsprograms auf den Zielprozessor;
Mittel zum Ausführen des Steuerungsprogramms auf dem Zielprozessor;
**dadurch gekennzeichnet, dass** der Codegenerator ausgebildet ist, einen ersten Laufzeitmesspunkt assoziiert mit dem Anfang und einen zweiten Laufzeitmesspunkt assoziiert mit dem Ende der Funktion in das Steuerungsprogramm einzufügen und den für eine Ausführung der Funktion verwendeten Cache des Zielprozessors unmittelbar vor dem ersten Laufzeitmesspunkt in einen vorbestimmten Zustand zu versetzten, wobei die Vorrichtung ferner Mittel zum Empfangen und Auswerten der an den Laufzeitmesspunkten bei der Ausführung des Steuerungsprogramms gemessenen Werte aufweist.

9. Vorrichtung nach Anspruch 8 wobei die Mittel zum Auswerten der Laufzeitmesspunkte ausgebildet sind, die Funktionsblöcke im graphischen Entwicklungsmodell mit den ausgewerteten Laufzeitwerten der entsprechenden Funktionen zu annotieren.

10. Vorrichtung nach Anspruch 9 wobei sich der Zielprozessor auf einem Evaluationsboard befindet.
